Europäisches Patentamt

European Patent Office

Office européen des brevets

(11) Numéro de publication: **0 524 363 A1**

## (12) DEMANDE DE BREVET EUROPEEN

(21) Numéro de dépôt: **91402081.3**

(22) Date de dépôt: **25.07.91**

(51) Int. Cl.5: **G01R 33/06**

(43) Date de publication de la demande:
**27.01.93 Bulletin 93/04**

(84) Etats contractants désignés:
**AT BE CH DE DK ES FR GB GR IT LI LU NL SE**

(71) Demandeur: **SOCIETE D'APPLICATIONS GENERALES D'ELECTRICITE ET DE MECANIOUE SAGEM**
**6, Avenue d'Iéna**
**F-75783 Paris Cédex 16(FR)**

(72) Inventeur: **Poirier, Michel**
**136 rue Saint Jean**
**95300 Pontoise(FR)**

(74) Mandataire: **Bloch, Gérard et al**
**2, square de l'Avenue du Bois**
**F-75116 Paris(FR)**

(54) **Dispositif de mesure d'un champ magnétique à l'aide d'au moins un barreau magnétorésistant.**

(57) Un barreau (1, 2) magnétorésistant baigne dans le champ magnétique ($H_x$) à mesurer. Le barreau est parcouru par un courant (I) dont la direction est celle de l'axe du barreau (1, 2). Un courant ($I_P$) parcours un conducteur auxiliaire (3) pour engendrer un champ magnétique auxiliaire tel que le courant (I) qui parcourt ledit barreau (1, 2) et la composante ($\vec{M_1}$, $\vec{M_2}$), non-induite par ledit champ magnétique ($H_x$) à mesurer, du vecteur aimantation dudit barreau (1, 2) aient des directions respectives formant un angle ($i_1$, $i_2$) de valeur non-nulle choisie pour que la mesure de la résistance du barreau (1,2) soit représentative de la valeur du champ à mesurer, avec une sensibilité convenable.

L'invention s'applique notamment pour la détermination de la direction du Nord, pour la localisation d'une source magnétique, et pour la mesure de courant sans contact.

FIG.1

La présente invention a pour objet un dispositif de mesure d'un champ magnétique à l'aide d'au moins un barreau magnétorésistant.

Un tel dispositif permet la mesure de l'intensité d'un champ magnétique de direction déterminée, et notamment du champ magnétique créé par un courant circulant dans un conducteur, en vue de la mesure sans contact de ce courant. Il permet également, lorsqu'il comporte au moins deux ou trois barreaux orthogonaux, la détermination de l'amplitude et de la direction d'un champ magnétique de direction inconnue, en vue de la détermination de la direction de la source de ce champ magnétique, ou de la direction du Nord, lorsque le champ magnétique dont il s'agit est le champ magnétique terrestre.

Dans un barreau magnétorésistant, c'est-à-dire siège du phénomène connu sous le nom de magnétorésistance, la valeur de la résistance du barreau dépend du champ magnétique dans lequel baigne le barreau. Plus précisément, la valeur $R_M$ de cette résistance dépend de la valeur de l'angle i entre la direction du courant qui parcourt le barreau et celle du vecteur aimantation de ce barreau, selon la formule :

$$R_M = R (1 + r \cos^2 i) \qquad (1)$$

formule dans laquelle :
- R est la résistance du barreau lorsque l'angle i est égal à 90 degrés, et
- r est un coefficient caractéristique du matériau.

De façon connue, le champ démagnétisant tend naturellement, en bordure du barreau, à aligner l'aimantation avec le bord du barreau.

En l'absence de dispositif particulier, le courant qui parcourt le barreau est dirigé selon l'axe longitudinal du barreau.

La composante permanente de l'aimantation est, en principe, également dirigée selon l'axe longitudinal du barreau, du fait d'une part de la forme allongée du barreau et donc de l'anisotopie de forme, et d'autre part de la direction de l'anisotropie intrinsèque du matériau magnétique, choisie pour qu'il en soit ainsi. Il en résulte que, en l'absence de champ magnétique extérieur, l'angle i est nul, la résistance du barreau est maximale et sa valeur $R_{MM}$ vaut :

$$R_{MM} = R (1 + r) \qquad (2).$$

Par contre, en présence d'un champ magnétique extérieur, il apparaît une composante induite du vecteur aimantation, dirigée comme le champ magnétique extérieur.

Il en résulte que, si le champ magnétique extérieur n'est pas dirigé selon l'axe longitudinal du barreau, le vecteur aimantation prend une direction différente de celle de l'axe longitudinal du barreau. L'angle i prend une valeur non nulle, et la résistance du barreau prend une valeur plus faible qu'en l'absence de champ magnétique extérieur.

La valeur minimale de la résistance du barreau est obtenue dans le cas où le champ magnétique extérieur est de direction orthogonale à l'axe longitudinal du barreau, et de valeur assez élevée pour que l'on puisse combattre l'effet du champ démagnétisant. Dans ce cas, le vecteur aimantation est perpendiculaire à l'axe longitudinal du barreau, et l'angle i est donc égal à 90 degrés.

La résistance du barreau est alors minimale et sa valeur $R_{Mm}$ vaut :

$$R_{Mm} = R \qquad (3)$$

Ainsi, la valeur de la résistance d'un barreau présentant le phénomène de magnétorésistance est liée au champ magnétique dans lequel baigne le barreau, et la mesure de la valeur de cette résistance peut donc constituer une mesure de ce champ magnétique. En particulier, dans le cas pratique le plus fréquent où le champ magnétique à mesurer est faible devant le champ d'anisotropie de forme, l'angle i est proportionnel, en première approximation, à la composante du champ à mesurer dirigée perpendiculairement à l'axe longitudinal du barreau. Le champ d'anisotropie de forme est celui nécessaire pour parvenir à saturation dans la direction perpendiculaire à l'axe du barreau.

La plupart des matériaux conducteurs sont le siège d'un phénomène de magnétorésistance, mais ce phénomène est particulièrement fort dans les alliages fer-nickel et fer-nickel-cobalt. Pour ces matériaux, le coefficient r est particulièrement élevé. Ces matériaux sont donc ceux qui sont, en principe, les plus utilisés en pratique.

Si l'on ne prend aucune précaution particulière, l'angle i est nul en l'absence de champ magnétique extérieur, comme cela a déjà été signalé. Il en résulte alors une sensibilité relativement faible, dans la mesure où il faut appliquer un champ extérieur relativement important pour obtenir une variation de résistance décelable. En effet, la courbe qui représente les variations de la résistance $R_M$ en fonction de l'angle i, selon la relation (1), est à tangente horizontale au voisinage de la valeur i = 0.

Par contre, cette courbe présente une pente maximale pour i = 45 degrés. Il en résulte que la sensibilité la meilleure est obtenue si on s'arrange pour que, en l'absence de champ magnétique extérieur, l'angle i soit égal à 45 degrés.

Pour qu'il en soit ainsi, il est connu de prendre des mesures, qui vont être maintenant décrites, pour que les lignes de courant dans le barreau soient orientées selon une direction formant un angle de 45 degrés avec l'axe longitudinal du barreau selon lequel est orientée la composante permanente du vecteur aimantation.

En principe, le barreau est réalisé par dépôt, sur un substrat isolant, d'une couche mince en matériau présentant le phénomène de magnétorésistance. La couche a la forme d'un rectangle allongé, le courant arrivant par un petit côté du rectangle et repartant par le petit côté opposé.

Un premier type de mesure permettant d'orienter les lignes de courant à 45 degrés par rapport à l'axe longitudinal d'un tel barreau consiste à prévoir, en contact avec ce barreau, une pluralité de pavés en matériau beaucoup plus conducteur que celui du barreau. Chaque pavé s'étend entre les deux grands côtés du rectangle, sur toute la largeur de celui-ci, selon une direction inclinée à 45 degrés par rapport à l'axe longitudinal du rectangle. Entre deux pavés consécutifs s'étend une zone libre de dimension comparable à celle des pavés. Cet agencement donne au barreau, lorsqu'il est vu de dessus, une physionomie qui rappelle celle des enseignes traditionnelles de barbier formées d'un barreau décoré de bandes inclinées colorées. Pour cette raison, un tel barreau est dit du type "enseigne de barbier", ou encore, pour adopter la terminologie anglosaxonne utilisée par l'homme du métier, du type "barber pole".

Dans un tel barreau, le courant ne circule pas dans les zones du barreau disposées sous les pavés conducteurs, car il est dévié, comme il le serait par un shunt, par chacun des pavés. Par contre, dans les zones libres comprises entre deux pavés, le courant passe dans le barreau, en suivant des lignes de courant perpendiculaires au bord des pavés, et donc inclinées à 45 degrés par rapport à la composante permanente du vecteur aimantation.

Les barreaux réalisés selon cette technique connue souffrent cependant d'un certain nombre d'inconvénients. Tout d'abord, ils sont relativement difficiles à fabriquer. En effet, les pavés conducteurs sont réalisés par masquage et attaque chimique d'une couche métallique relativement épaisse déposée sur une couche mince, de l'ordre de 500 angstroms, de matériau magnétorésistant, tel que le fer-nickel, par exemple. Il en résulte une difficulté de gravure pour, dans les zones ou le métal de la couche épaisse doit être enlevé, cesser l'attaque dès qu'il en est ainsi, afin de ne pas attaquer ou oxyder la couche de fer-nickel. Ceci a pour conséquence une difficulté à maîtriser avec une grande précision la valeur de la résistance totale du barreau. Il en résulte des difficultés pour produire des barreaux dont les propriétés sont rigoureusement identiques. Or ces barreaux sont en général montés en pont, pour lesquels il faut disposer de quatre exemplaires dont les résistances doivent être rigoureusement égales, ce qui oblige à monter chaque barreau en série avec une résistance complémentaire ajustable au laser, par exemple.

De plus, un dispositif de mesure de champ magnétique réalisé à l'aide de tels barreaux n'est linéaire que sur un domaine relativement limité de valeurs de l'intensité du champ à mesurer, pour lequel l'angle entre le courant et le vecteur aimantation ne devient ni trop proche de 0 degrés, ni trop proche de 90 degrés.

Enfin, comme chaque barreau doit avoir un vecteur aimantation dont la composante permanente est alignée avec son axe longitudinal, il est impossible de réaliser, à partir d'une unique couche de matériau magnétorésistant déposée sur un unique substrat, des barreaux d'axes perpendiculaires pour mesurer simultanément deux composantes orthogonales du champ magnétique par exemple. En effet, l'orientation de la composante permanente du vecteur aimantation est celle de la direction de l'anisotropie intrinsèque de la couche, encore appelée "axe aisé", qui est identique pour toutes les zones de la couche. Pour réaliser deux dispositifs de mesure perpendiculaires l'un par rapport à l'autre, il est donc nécessaire de réaliser séparément deux couches différentes, dont les propriétés, et notamment le coefficient r ainsi que le comportement en température, risquent de ne pas être identiques, ce qui introduit des causes d'erreur dans la détermination du champ magnétique.

Un deuxième type de mesure permettant d'orienter les lignes de courant à 45 degrés par rapport à l'axe longitudinal du barreau consiste à pratiquer, dans ce barreau, des fentes inclinées à 45 degrés qui s'étendent sur presque toute la largeur du rectangle que forme le barreau, alternativement à partir d'un grand côté et de l'autre. Ces fentes, formant ainsi des chicanes, obligent le courant à suivre un trajet en zig-zag dont les parties rectilignes sont parallèles aux fentes. Si celles-ci sont suffisamment fines, leur présence n'affecte pas l'orientation de la composante permanente du vecteur aimantation qui reste donc longitudinal. Pour qu'il en soit ainsi, il est toutefois nécessaire que la largeur des fentes soit de l'ordre du micron, ce qui entraîne des difficultés importantes de fabrication et de reproductibilité. Par ailleurs, ces barreaux fendus, comme les barreaux de type "enseigne de barbier" souffrent d'une linéarité limitée, et du fait que deux d'entre eux ne peuvent être, à la fois, de directions perpendiculaires et réalisés dans une même couche de matériau magnétorésistant.

La présente invention vise à procurer un dispositif ne souffrant pas des inconvénients précédents, et qui présente, de plus, une sensibilité plus grande que celle des dispositifs connus.

A cet effet, elle a pour objet un dispositif de mesure d'un champ magnétique comprenant au moins un barreau magnétorésistant qui baigne dans ledit champ magnétique à mesurer, et des moyens de mesure de la valeur de la résistance dudit barreau, dispositif dans lequel le courant qui parcourt ledit barreau et la composante, non-induite par ledit champ magnétique à mesurer, du vecteur aimantation dudit barreau ont des directions respectives formant un angle de valeur non-nulle choisie pour donner au dispositif une sensibilité convenable, dispositif caractérisé par le fait que la direction dudit courant est celle dudit barreau et qu'il est prévu des moyens de génération d'un champ magnétique auxiliaire pour donner à ladite composante du vecteur aimantation une direction convenable.

Dans le dispositif de l'invention, du fait que la direction du courant est celle du barreau, il n'est pas nécessaire de réaliser des pavés ou des fentes, ce qui simplifie grandement la fabrication, et permet la reproductibilité des caractéristiques des barreaux réalisés, pour leur utilisation en pont. Par ailleurs, du fait que la composante du vecteur aimantation non induite par le champ à mesurer est déterminée par l'anisotropie de forme, l'anisotropie intrinsèque , ainsi que par le champ auxiliaire, il n'est plus nécessaire, comme dans les dispositifs connus, que l'anisotropie intrinsèque de la couche de matériau magnétorésistant soit dirigée selon l'axe du barreau. Il devient alors possible de réaliser des barreaux orientés perpendiculairement à partir d'une unique couche, de façon à ce qu'ils se comportent de façon identique.

Avantageusement, lesdits moyens de génération sont agencés pour que ledit champ auxiliaire varie périodiquement, et lesdits moyens de mesure mettent en oeuvre une détection synchrone à la fréquence de variation dudit champ auxiliaire.

Dans ce cas, la sensibilité est améliorée, car la détection synchrone permet la détection de signaux noyés dans le bruit, donc de variations très faibles de la valeur de la résistance du barreau.

Avantageusement encore, le dispositif comprend au moins une paire de barreaux identiques parcourus par des courants identiques, ledit champ magnétique auxiliaire passe périodiquement, pour chacun desdits barreaux, de l'un à l'autre de deux états, de façon à ce que la configuration relative de ladite composante et dudit champ magnétique à mesurer, pour un barreau et pour un des deux états, soit identique à celle prise pour l'autre barreau et pour l'autre des deux états.

Dans ce cas, tout se passe comme si c'était le champ à mesurer lui-même qui changeait périodiquement de signe, le champ auxiliaire de polarisation restant constant. Il en résulte que l'influence de l'hystérésis, ainsi que celle de la valeur de ce champ auxiliaire, est éliminée, et on obtient directement une grandeur représentant le champ magnétique à mesurer.

Dans la forme de réalisation préférée, lesdits moyens de génération dudit champ auxiliaire comprennent un conducteur parcouru par un courant et, dans le cas où on utilise une paire de barreaux et un champ auxiliaire basculant entre deux états, l'intensité dudit courant et la disposition dudit conducteur sont choisis pour que l'angle entre ladite composante et ledit champ magnétique à mesurer pour l'un des barreaux soit le supplément de l'angle entre ladite composante et ledit champ magnétique à mesurer pour l'autre barreau, lesdites composantes changeant de signe lorsque ledit courant change de signe.

Selon une autre caractéristique de l'invention, il est prévu au moins un conducteur de retour au voisinage dudit barreau et des moyens pour engendrer un courant de retour dans ledit conducteur de retour, en réponse à la valeur de la résistance dudit barreau, tel qu'il crée sur ledit barreau un champ égal et opposé audit champ à mesurer.

Dans ce cas, le dispositif présente une grande linéarité, est insensible à la température, et présente un facteur d'échelle précis, sans réglage. De plus, le courant de retour peut être transporté à distance, sans que la chute de tension dans les fils de connexion ne soit une source de perturbation.

Dans une forme de réalisation particulière, il est prévu au moins deux barreaux d'axes perpendiculaires, obtenus par gravure d'une unique couche dont l'axe aisé est incliné à 45 degrés par rapport à chacun des axes des deux barreaux.

Un tel dispositif est approprié à la détermination de l'amplitude et de la direction d'un champ inconnu.

Selon encore une autre caractéristique de l'invention, ledit barreau forme, avec un autre barreau identique, un circuit magnétique fermé interrompu par deux entrefers, de façon à ce que ledit barreau ne comprenne qu'un unique domaine.

Dans ce cas, la sensibilité est améliorée, du fait de l'absence, à l'intérieur du barreau, de parois de séparation des domaines.

La présente invention sera mieux comprise à la lecture de la description suivante de la forme de réalisation préférée du dispositif de l'invention, faite en se référant aux dessins annexés, sur lesquels :

- la figure 1 représente un schéma de principe illustrant le fonctionnement d'une paire de barreaux magnétorésistants selon l'invention,
- les figures 2a et 2b représentent chacune une paire de barreaux magnétorésistants selon l'art antérieur et selon l'invention, respectivement,
- la figure 3 représente schématiquement un pont de quatre barreaux magnétorésistants pour la mesure d'un champ magnétique inconnu, pont réalisé à l'aide de deux paires de barreaux conformes à la paire de la figure 1,

- les figures 4a, 4b et 4c représentent un exemple de forme d'onde pour le courant de polarisation des paires de barreaux des figures 1 et 3, par exemple,

- la figure 5 représente la paire de barreaux de la figure 1, pourvue d'un conducteur auxiliaire de retour,

- la figure 6 représente un schéma d'un circuit électronique pour la mise en oeuvre d'un dispositif utilisant un pont de deux paires de barreaux conformes à celle de la figure 5,

- la figure 7 représente un schéma d'implantation d'un pont utilisant une pluralité de paires de barreaux conformes à celles des figures 1 ou 5, et,

- la figure 8 représente une vue en perspective d'une portion d'un barreau de la paire de la figure 5 et de ses conducteurs auxiliaires, dans une variante réalisable sous forme de circuit intégré.

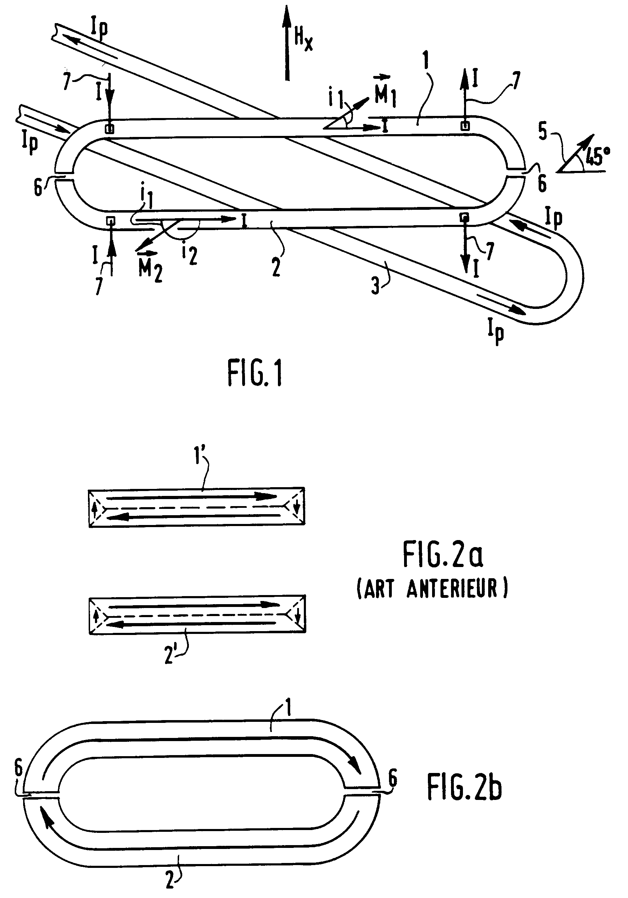

Sur la figure 1, on a représenté une paire de barreaux 1 et 2, magnétorésistants, c'est-à-dire dont la résistance dépend du champ magnétique dans lequel ils baignent, et donc utilisables, comme cela a déjà été signalé, pour la détermination de la composante de ce champ magnétique orthogonale à l'axe de chacun de ces barreaux 1 et 2, composante notée ici $H_x$.

De manière connue, les barreaux 1 et 2 sont réalisés par gravure une couche mince de fer-nickel ou de fer-nickel-cobalt, déposée sur un substrat non représenté.

Pour des raisons qui seront mieux comprises dans la suite, les barreaux 1 et 2 qui sont, dans leurs parties centrales, rectilignes et parallèles entre eux, sont tels que les extrémités de l'un sont recourbées vers les extrémités respectives de l'autre. Ainsi, l'ensemble des deux barreaux 1 et 2 prend une forme qui rappelle celle de la piste d'un stade olympique à deux parties rectilignes raccordées par des parties arrondies, des entrefers 6 qui séparent les barreaux l'un de l'autre étant disposés au milieu de chacune des parties arrondies.

Sur chacun des barreaux 1 et 2, il est prévu, à chacune des extrémités de la partie rectiligne, deux conducteurs 7 qui permettent de faire circuler dans le barreau un courant continu I, de sens identique pour les deux barreaux 1 et 2.

De façon connue, la résistance d'un barreau comme le barreau 1 ou 2 est donnée par la formule (1) déjà citée :

$$R_M = R (1 + r \cos^2 i) \quad (1)$$

formule dans laquelle i est l'angle entre la direction du courant I et celle du vecteur aimantation $\vec{M}$, R est la résistance du barreau lorsque l'angle i est égal à 90 degrés, et r est un coefficient caractéristique du matériau.

Afin que les composantes $\vec{M_1}$ et $\vec{M_2}$, non-induites par le champ $H_x$ à mesurer, du vecteur aimantation de chacun des barreaux l et 2, respectivement, forment, avec les courants I, des angles de valeurs non-nulles, il est prévu ici un conducteur 3, parcouru par un courant de polarisation $I_P$, qui engendre un champ magnétique auxiliaire pour donner à $\vec{M_1}$ et à $\vec{M_2}$ des orientations convenables.

Le conducteur 3 a ici la forme d'une épingle à cheveux dont les parties rectilignes sont inclinées par rapport aux parties rectilignes des barreaux 1. Une première branche du conducteur 3 passe au voisinage de la partie centrale du barreau 1, tandis que la deuxième branche du conducteur 3 passe au voisinage de la partie centrale du barreau 2. L'inclinaison relative du conducteur 3 et des barreaux 1 et 2, et l'intensité du courant de polarisation $I_P$ sont choisis pour que l'angle $i_1$ entre $\vec{M_1}$ et I soit ici égal à 45 degrés, et l'angle $i_2$ entre $\vec{M_2}$ et I égal au supplémentaire de $i_1$, c'est-à-dire ici 135 degrés.

Naturellement, les valeurs 45 degrés et 135 degrés qui correspondent, comme cela a été signalé, à la sensibilité maximale, ne sont pas impératives, et il est possible de choisir toutes autres valeurs non-nulles qui donnent une sensibilité convenable.

Les figures 2 permettent de comprendre les avantages de la forme particulière donnée aux barreaux 1 et 2. Sur la figure 2a, on a représenté une paire de barreaux 1' et 2' rigoureusement rectilignes et non couplés magnétiquement, comme ceux utilisés dans les dispositifs de l'art antérieur. Les lois du magnétisme font qu'il apparaît, dans chacun de ces barreaux, quatre des domaines connus par l'homme du métier comme "domaines de Weiss", séparés par des parois représentées en trait pointillés. A l'intérieur de chaque domaine, l'induction magnétique est de direction et de sens uniforme, représentée par une flèche sur la figure 2a. Les directions et sens de l'induction dans chacun des domaines sont tels qu'à l'intérieur d'un barreau, les différents vecteurs inductions forment un circuit qui se reboucle sur lui-même. Dans la pratique, les parois entre les domaines n'ont pas la forme régulière de la figure 2a, elles se déplacent lorsque le champ magnétique extérieur varie, et elles sont à l'origine du phénomène d'hystérésis, leur position n'étant pas reproductible. Ce phénomène de déplacement des parois est ainsi à l'origine de bruits qui limitent la sensibilité, c'est-à-dire la valeur minimale du champ extérieur que l'on peut détecter en mesurant la valeur de la résistance du barreau.

Afin d'éviter cet inconvénient, la disposition déjà décrite des barreaux 1 et 2, formant un circuit presque fermé et reprise sur la figure 2b permet de n'avoir qu'un unique domaine à l'intérieur d'un barreau, la fermeture du circuit de l'induction étant assurée par l'autre barreau, du fait que les entrefers 6 sont suffisamment étroits pour ne pas perturber le circuit magnétique, tout en assurant l'isolement galvanique entre les barreaux 1 et 2. La sensibilité des dispositifs réalisés à l'aide des barreaux de la figure 2b sera donc sensiblement améliorée par rapport à celle obtenue avec les barreaux de la figure 2a. Il est à noter que la nécessité de former des paires de barreaux n'est pas ici une contrainte, car comme cela a déjà été signalé, un dispositif complet comprend en principe un pont de quatre barreaux identiques, qui sera donc ici réalisé avec deux paires telles que celle des figures 1 ou 2b.

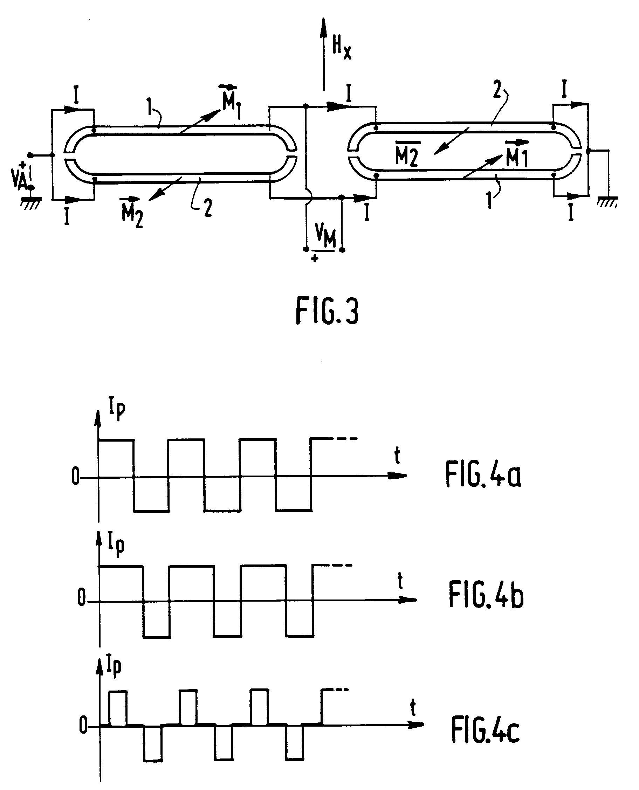

La figure 3 décrit un tel agencement. Sur cette figure, on n'a pas représenté, dans un souci de simplicité, le conducteur 3 parcouru par le courant de polarisation $I_P$. Le pont est alimenté sous une tension continue $V_A$ par une source non représentée. Une première et une deuxième connexions sont disposées entre la tension $V_A$ et la masse. La première connexion comprend, du côté de la source, le barreau 1 d'une première paire, et du côté de la masse le barreau 2 d'une deuxième paire. La deuxième connexion comprend, du côté de la source, le barreau 2 de la première paire, et, du côté de la masse, le barreau 1 de la deuxième paire. Chacune des première et deuxième connexions est parcourue par le courant I créé par la source de la tension $V_A$. La tension de sortie $V_M$, prise entre les deux noeuds qui, sur la première et la deuxième connexion, séparent les deux barreaux, est, de façon connue, représentative des variations des valeurs des résistances des barreaux 1 et 2, et donc de la valeur de la composante $H_x$ du champ perpendiculaire à l'axe longitudinal des barreaux 1 et 2.

Lorsque le courant de polarisation $I_P$ reste constant, la tension $V_M$ est une tension continue ou lentement variable, comme la composante $H_x$, qui peut être difficile à mesurer lorsqu'elle est particulièrement faible.

C'est pourquoi il est intéressant d'utiliser un courant de polarisation $I_P$ périodique, qui engendre un champ auxiliaire périodique, ce qui a pour conséquence une variation périodique, de même fréquence, de la tension $V_M$. Un circuit de détection synchrone recevant la tension $V_M$ commandé par un signal à la fréquence du courant de polarisation $I_P$, permet d'extraire la partie utile de $V_M$, même lorsque celle-ci est noyée dans le bruit.

Dans ce cas, il est particulièrement avantageux de prévoir que, lorsque le courant de polarisation $I_P$ circule dans un sens, les angles $i_1$ et $i_2$ de la figure 1 soient supplémentaires, tandis que, lorsque le courant $I_P$ devient égal et opposé à la valeur précédente, les vecteurs $\vec{M_1}$ et $\vec{M_2}$ deviennent eux aussi égaux et opposés à leur valeur initiale. Ceci est notamment rendu possible du fait que la composante longitudinale du vecteur aimantation est, de façon connue de l'homme du métier, susceptible de changer brusquement de sens sous l'action d'un champ extérieur relativement faible, dirigé selon la longueur du barreau.

Il en résulte que, si le courant $I_P$ varie périodiquement en créneaux qui s'écartent symétriquement de la valeur nulle, comme cela est représenté sur la figure 4a, par exemple, tout se passe comme si le courant $I_P$ restait constant, le champ $H_x$ changeant de signe à la fréquence des changements de signe du courant $I_P$. En effet, entre les alternances positives du courant $I_P$ et ses alternances négatives, les rôles des barreaux 1 et 2 s'intervertissent, ce qui serait le cas si, au lieu du courant $I_P$, c'était le champ $H_x$ qui changeait de signe. L'influence de l'hystérésis se trouve ainsi éliminée, ainsi que celle de la valeur de $I_P$ qui n'intervient plus.

Pour parvenir à ce résultat, il n'est pas nécessaire que la forme d'onde du courant $I_P$ soit celle de la figure 4a, où les alternances positives de $I_P$ sont de durée égale à celle des alternances négatives. Ainsi, les formes d'onde des figures 4b et 4c peuvent convenir. Pour la forme d'onde de la figure 4b, les alternances positives sont plus longues que les alternances négatives. Pour la forme d'onde de la figure 4c, les alternances positives sont séparées des alternances négatives par des passages à zéro.

Sur la figure 1, la flèche 5 représente l'axe aisé, ou direction de facile aimantation, de la couche de matériau magnétorésistant dans laquelle sont réalisés les barreaux 1 et 2. Ici, l'axe aisé est incliné à 45 degrés par rapport à l'axe longitudinal des barreaux 1 et 2. Cette caractéristique n'est pas obligatoire dans le cas considéré jusqu'à présent où les barreaux sont tous parallèles entre eux et orthogonaux à la composante $H_x$ que l'on désire mesurer. Dans ce cas, l'orientation de l'axe aisé est, de façon préférentielle, selon la longueur du barreau. Toutefois, lorsque l'on désire mesurer la direction d'un champ magnétique de direction inconnue, il est nécessaire de disposer d'au moins deux ponts de barreaux magnétorésistants, la direction commune des barreaux d'un pont étant perpendiculaire à celle des barreaux de l'autre pont. Dans ce cas, il est judicieux de placer l'axe aisé de la couche à 45 degrés par rapport à chacune de ces directions, de façon à rendre rigoureusement identique le comportement de chacun des ponts. Un des ponts délivre une tension $V_{Mx}$ liée à la composante $H_x$ du champ, l'autre pont une tension $V_{My}$ liée à la composante $H_y$, et un calculateur permet la détermination de la direction inconnue D du champ grâce à la relation:

$$D = \text{Arc tg } (V_{Mx}/V_{My}) \quad (4)$$

Comme, du fait de la proximité des deux ponts, leurs comportements respectifs peuvent être considérés comme identiques, le rapport $V_{Mx}/V_{My}$ reste égal au rapport des deux composantes du champ, même si la température ou d'autres facteurs viennent influencer ces comportements. Il est à noter que cette propriété d'une paire de ponts de directions perpendiculaires réalisés sur un même substrat peut être mise à profit pour d'autres applications que la mesure de la direction inconnue d'un champ. Par exemple, un des ponts, soumis à un champ magnétique connu, est utilisé pour étalonner l'autre, qui mesure un champ inconnu, afin de s'affranchir des variations possibles du comportement des ponts, en fonction la température, par exemple.

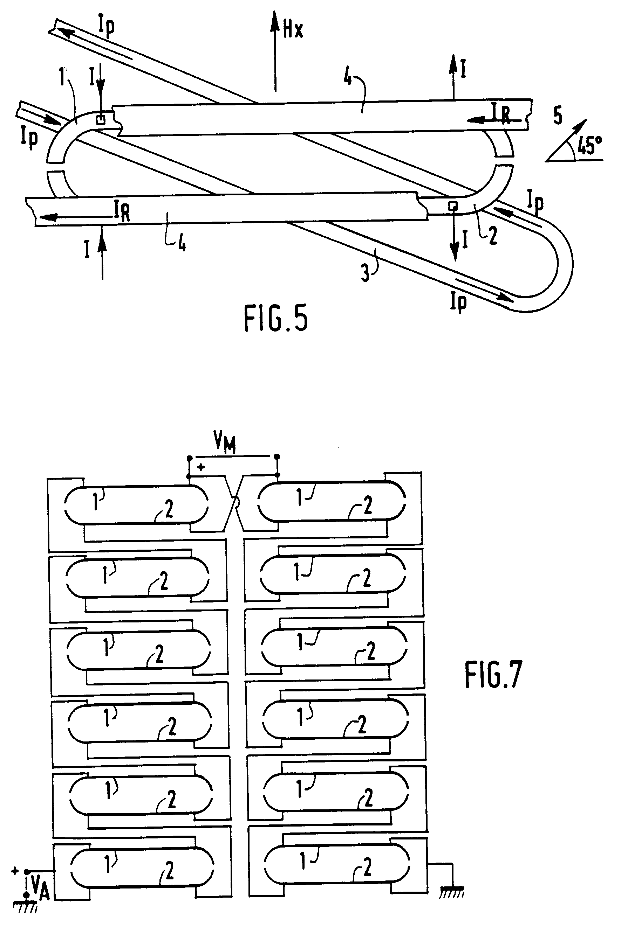

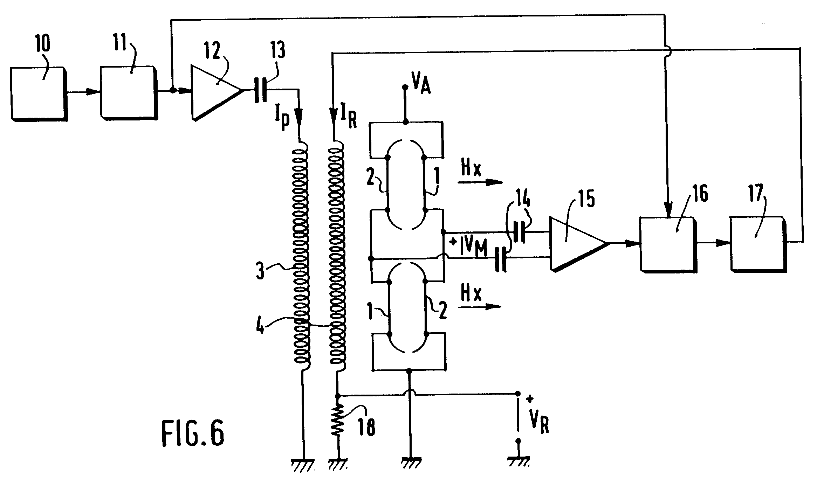

Sur la figure 5, on a représenté la paire de barreaux magnétorésistants 1 et 2 et le conducteur 3 déjà représentés sur la figure 1, ainsi qu'un conducteur 4, dit conducteur de retour, dont le rôle va maintenant être expliqué. Ce conducteur 4 est parcouru par un courant de retour $I_R$, et il est disposé au voisinage des parties rectilignes des barreaux 1 et 2, parties rectilignes parcourues par le courant I. Ici, le conducteur 4 recouvre, sans contact électrique, les barreaux 1 et 2. Les conducteurs de la figure 5 sont donc ici situés dans trois plans différents et isolés électriquement, assez proches cependant pour que chacun des conducteurs baigne dans le champ magnétique crée par les autres. Ainsi, dans le plan le plus éloigné de l'observateur de la figure 5, se trouve le conducteur 3 parcouru par le courant de polarisation $I_P$, de préférence d'amplitude constante, mais qui change de signe périodiquement, et qui a pour fonction d'engendrer un champ magnétique auxiliaire destiné notamment à améliorer la sensibilité vis-à-vis du champ inconnu $H_x$. Dans le plan médian, se trouvent les barreaux 1 et 2 parcourus par le courant continu I qui permet la mesure des variations de résistance et donc du champ inconnu $H_x$. Enfin, dans le plan le plus proche de l'observateur, se trouve le conducteur 4 parcouru par le courant de retour $I_R$. Le courant de retour $I_R$ est destiné à produire, au voisinage des parties rectilignes des barreaux 1 et 2, un champ en permanence égal et opposé au champ $H_x$, grâce par exemple au circuit de la figure 6.

Sur le circuit de la figure 6, on retrouve le pont de quatre barreaux de la figure 3, alimenté par la tension continue $V_A$ et délivrant une tension $V_M$.

Les conducteurs 3 et 4 de la figure 5 sont, dans un souci de simplicité, schématisés par des enroulements sur la figure 6. Le courant de polarisation $I_P$ est produit dans le conducteur 3 grâce à un ensemble de circuits disposés en cascade et comprenant successivement une horloge 10, un diviseur de fréquence 11, divisant par deux et réalisé ici à partir d'une bascule, un amplificateur 12 et un condensateur 13.

Le signal $V_M$ en sortie du pont est appliqué, par l'intermédiaire de deux condensateurs 14 à un amplificateur différentiel 15, suivi d'un circuit de détection synchrone 16, qui reçoit le signal de sortie du diviseur 11.

La sortie du circuit de détection synchrone 16 est reliée à l'entrée d'un circuit d'asservissement, comprenant essentiellement un intégrateur, qui délivre le courant $I_R$ circulant dans le conducteur 4. Une résistance 18 de faible valeur est disposée entre la masse et l'extrémité du conducteur 4 opposée à la sortie de l'intégrateur 17.

Le circuit de la figure 6 fonctionne de la façon suivante. L'ensemble 10, 11, 12 et 13 fournit, de façon évidente et très simple, un courant $I_P$ dont la forme d'onde est celle de la figure 4a, puisque les alternances positives et négatives sont égales et de durée égale à la période d'horloge, le condensateur 13 ayant pour fonction d'arrêter la composante continue afin de bien centrer le courant $I_P$ autour de la valeur nulle.

En l'absence de conducteur 4, le signal $V_M$ serait représentatif de la composante du champ à mesurer $H_x$, mais grâce au conducteur 4 et au sens dans lequel le courant $I_R$ parcourt ce conducteur, il se produit une compensation automatique de la composante $H_x$ par le champ crée par le conducteur 4, de façon à ce que la tension $V_M$ reste pratiquement nulle.

Le courant $I_R$ est donc une image de la composante $H_x$ du champ inconnu et sa mesure, par l'intermédiaire de la tension $V_R$ aux bornes de la résistance 18, permet donc de connaître la composante $H_x$ du champ.

Avec le circuit de la figure 6, on obtient un dispositif présentant une très bonne linéarité, puisque les barreaux travaillent toujours avec un champ extérieur pratiquement nul. Le facteur d'échelle est très précis et ne nécessite pas de réglage, et le dispositif est insensible à l'influence de la température. Enfin, il peut y avoir une distance relativement grande entre la sortie de l'intégrateur 17 et le conducteur 4, puisque c'est la valeur du courant $I_R$ qui importe, quelle que soit la chute de tension dans les fils de connexion.

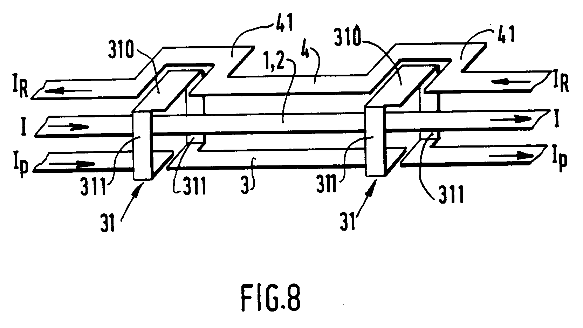

Naturellement, le pont peut comprendre plus de deux paires de barreaux telles que celles des figures 1 et 5. Ainsi sur la figure 7 est représenté un pont qui comprend au total 12 paires de barreaux réparties en deux colonnes de six paires. Tous les barreaux supérieurs, portant la référence 1, de chaque colonne, sont connectés en série pour former deux bras opposés du pont, tandis que tous les barreaux inférieurs, portant la référence 2, de chaque colonne, sont connectés en série pour former les deux autres bras du pont. Une telle structure, outre le fait qu'elle a une forme proche de celle d'un carré qui facilite son implantation, présente l'avantage de réduire les dispersions, du fait que la répartition des paires de résistance sur l'ensemble de la surface de mesure produit un moyennage des éventuelles inhomogénéités du champ à mesurer, ou du dispositif de mesure, inhomogénéités qui pourraient fausser les mesures.

Sur la figure 8 est représentée en perspective, une partie des barreaux 1 ou 2 et des conducteurs associés 3 et 4, dans une structure pouvant être réalisée sous forme de circuit intégré.

Le barreau 1 ou 2 occupe un plan horizontal intermédiaire, sa forme étant la même que sur les figures 1 ou 5.

Le conducteur 3 parcouru par le courant de polarisation $I_P$ occupe un plan horizontal inférieur. Au lieu d'être d'axe longitudinal incliné par rapport à l'axe longitudinal du barreau 1 ou 2, il lui est parallèle, l'absence d'inclinaison étant compensée par des boucles 31, formées de part en part par le conducteur 3 autour du barreau 1 ou 2. Chaque boucle 31 comprend, dans un plan horizontal supérieur à celui du plan du barreau 1 ou 2, une portion 310 reliée au conducteur 3 du plan inférieur par des métallisations verticales 311. La fréquence et l'emplacement des bouches 31 est choisie, ainsi que la valeur du courant $I_P$, pour que les composantes $M_1$ et $M_2$, non-induites par le champ à mesurer, des vecteurs aimantations, soient orientées convenablement.

Le conducteur 4, parcouru par le courant $I_R$, s'étend dans le même plan horizontal supérieur que les portions 310, parallèlement au barreau 1 ou 2, sauf au voisinage des portions 310, qu'il évite grâce à des décrochements 41.

Une telle structure, dans laquelle les conducteurs s'étendent dans des plans horizontaux superposés est facilement réalisable sous forme de circuit intégré de faible surface, et de coût relativement modeste.

Pour régler la gamme des valeurs de l'intensité du champ magnétique mesurable par l'un des dispositifs précédents, on règle, de façon connue, le rapport entre l'épaisseur et la largeur de chacun des barreaux magnétorésistants 1 ou 2. Lorsque ce rapport diminue, la valeur maximale de l'intensité du champ mesurable diminue, ce qui donne un dispositif plus adapté à la mesure des champs faibles.

Naturellement, la présente invention n'est pas limitée à la forme de réalisation et à ses variantes qui viennent d'être décrites.

C'est ainsi qu'il n'est pas obligatoire d'utiliser une paire de barreaux, et il serait possible de mettre en oeuvre le dispositif de l'invention avec un seul barreau.

De même, il serait possible de mettre en oeuvre l'invention avec un courant de polarisation périodique non symétrique autour de zéro, ou même avec un courant de polarisation continu. On pourrait aussi utiliser un aimant permanent pour engendrer le champ auxiliaire de polarisation.

Par ailleurs, dans le cas où l'on n'utilise pas de conducteur 4 de courant de retour $I_R$, il est clair que le schéma de la figure 6 peut être utilisé, le circuit 17 étant supprimé, et la sortie représentative de la composante $H_x$ étant la sortie du circuit de détection synchrone 16.

Enfin, bien que la forme de "piste olympique" presque fermée de chaque paire de barreaux 1 et 2 soit normalement destinée à être employée avec une polarisation du type de celle qui a été décrite, il serait possible de mettre en oeuvre des paires de barreaux ayant cette forme dans des dispositifs utilisant la polarisation connue du type "enseigne de barbier" ou barreau à fentes.

## Revendications

1. Dispositif de mesure d'un champ magnétique comprenant au moins un barreau (1, 2) magnétorésistant qui baigne dans ledit champ magnétique ($H_x$) à mesurer, et des moyens de mesure (15, 16) de la valeur de la résistance dudit barreau (1, 2), dispositif dans lequel le courant (I) qui parcourt ledit barreau (1, 2) et la composante ($\vec{M_1}$, $\vec{M_2}$), non-induite par ledit champ magnétique ($H_x$) à mesurer, du vecteur aimantation dudit barreau (1, 2) ont des directions respectives formant un angle (i) de valeur non-nulle pour donner au dispositif une sensibilité convenable, dispositif caractérisé par le fait que la direction dudit courant (I) est celle dudit barreau (1, 2) et qu'il est prévu des moyens de génération (10-13, 3) d'un champ magnétique auxiliaire pour donner à ladite composante ($\vec{M_1}$, $\vec{M_2}$) du vecteur aimantation une direction convenable.

2. Dispositif selon la revendication 1, dans lequel lesdits moyens de génération (10-13, 3) sont agencés pour que ledit champ auxiliaire varie périodiquement et lesdits moyens de mesure (15, 16) mettent en oeuvre une détection synchrone à la fréquence de variation dudit champ auxiliaire.

3. Dispositif selon la revendication 2, comprenant au moins une paire de barreaux (1, 2) identiques parcourus par des courants (I) identiques, dans lequel ledit champ magnétique auxiliaire passe périodiquement pour chacun desdits barreaux de l'un à l'autre de deux états, de façon à ce que la configuration relative de ladite composante ($\vec{M_1}$; $\vec{M_2}$) et dudit champ magnétique à mesurer ($H_x$), pour un barreau (1) et pour un des deux états, soit identique à celle prise pour l'autre barreau (2) et pour l'autre des deux états.

4. Dispositif selon l'une des revendications 1 à 3, dans lequel lesdits moyens de génération du champ auxiliaire comprennent un conducteur (3) parcouru par un courant ($I_P$).

5. Dispositif selon la revendication 4 en ce qu'elle dépend de la revendication 3, dans lequel l'intensité dudit courant ($I_P$) et la disposition dudit conducteur (4) sont choisis pour que l'angle ($i_1$) entre ladite composante ($\vec{M_1}$) et ledit champ magnétique à mesurer ($H_x$) pour l'un (1) des barreaux soit le supplément de l'angle ($i_2$) entre ladite composante ($\vec{M_2}$) et ledit champ magnétique à mesurer ($H_x$) pour l'autre barreau (2), lesdites composantes ($\vec{M_1}$, $\vec{M_2}$) changeant de signe lorsque ledit courant ($I_P$) change de signe.

6. Dispositif selon l'une des revendications 1 à 5, dans lequel il est prévu au moins un conducteur de retour (4) au voisinage dudit barreau (1, 2) et des moyens (15, 16, 17) pour engendrer un courant de retour ($I_R$) dans ledit conducteur de retour (4), en réponse à la valeur de la résistance dudit barreau (1, 2), tel qu'il crée sur ledit barreau (1, 2) un champ égal et opposé audit champ à mesurer ($H_x$).

7. Dispositif selon l'une des revendications 1 à 6, comprenant au moins deux barreaux d'axes orthogonaux, obtenus par gravure d'une unique couche dont l'axe aisé (5) est incliné à 45 degrés par rapport à chacun des axes des deux barreaux.

8. Dispositif selon l'une des revendications 1 à 7, dans lequel ledit barreau (1, 2) forme, avec un autre barreau (2, 1) identique, un circuit magnétique fermé interrompu par deux entrefers (6), de façon à ce que ledit barreau (1, 2) ne comprenne qu'un unique domaine.

9. Dispositif selon l'une des revendications 1 à 8, dans lequel il est prévu au moins quatre barreaux (1, 2) montés en pont.

10. Dispositif selon la revendication 9, dans lequel chacune des branches dudit pont est formée par la mise en série d'une pluralité de barreaux (1, 2), chacun desdits barreaux étant un élément similaire d'une paire de barreaux, lesdites paires étant réparties de façon à occuper une surface sensiblement carrée.

FIG.1

FIG.2a
(ART ANTERIEUR)

FIG.2b

FIG.3

FIG.4a

FIG.4b

FIG.4c

FIG.5

FIG.7

FIG.6

FIG.8

Office européen
des brevets

**RAPPORT DE RECHERCHE EUROPEENNE**

Numero de la demande

EP    91 40 2081

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 452 716 (SONY CORPORATION) <br> * page 8, ligne 11 - ligne 24 * <br> * page 24, ligne 23 - page 25, ligne 32 * <br> * figures 1,13 * <br> --- | 1,3,9 | G01R33/06 |
| A | US-A-4 533 872 (W.T. BOORD) <br> * colonne 2, ligne 48 - ligne 61 * <br> * colonne 4, ligne 46 - colonne 5, ligne 5 * <br> --- | 1,7,9 | |
| A | US-A-4 296 377 (H. OHKUBO) <br> * colonne 2, ligne 63 - colonne 3, ligne 28 * <br> * colonne 4, ligne 29 - colonne 5, ligne 36 * <br> * colonne 11, ligne 61 - colonne 12, ligne 6 * <br> * figures 3,12 * <br> ----- | 1,7,9,10 | |
| | | | **DOMAINES TECHNIQUES RECHERCHES (Int. Cl.5)** <br><br> G01R |

Le présent rapport a été établi pour toutes les revendications

| Lieu de la recherche | Date d'achèvement de la recherche | Examinateur |
|---|---|---|
| LA HAYE | 25 FEVRIER 1992 | SWARTJES H.M. |